# EUROPÄISCHE PATENTSCHRIFT

(11) **EP 3 189 593 B1**
(45) Veröffentlichungstag und Bekanntmachung des Hinweises auf die Patenterteilung: **10.10.2018**
(21) Anmeldenummer: 15756859.3
(22) Anmeldetag: 12.08.2015
(51) Int. Cl.: H03K 17/082, H03K 17/60, H03K 17/61, H03K 17/691

(54) **ELEKTRONISCHER SCHALTER**
ELECTRONIC SWITCH
RELAIS ÉLECTRONIQUE

(30) Priorität: 05.09.2014 DE 202014007096 U
(43) Veröffentlichungstag der Anmeldung: 12.07.2017
(73) Patentinhaber: Ellenberger & Poensgen GmbH, 90518 Altdorf (DE)
(72) Erfinder: ASANZA MALDONADO, Diego, Fernando, 90403 Nürnberg (DE)
(74) Vertreter: FDST Patentanwälte
(86) Internationale Anmeldenummer: PCT/EP2015/068592
(87) Internationale Veröffentlichungsnummer: WO 2016/034384

(56) Entgegenhaltungen:
- DE-A1-102011 114 366
- DE-U1- 20 302 275
- KR-A- 20140 006 082

## Beschreibung

Die Erfindung betrifft einen elektronischer Schalter zum Schalten einer Last, mit einem zwischen einem Gleichspannungsanschluss und einem Lastanschluss verlaufenden Strompfad, in den ein Leistungstransistor und ein den Laststrom erfassender Stromsensor geschaltet sind, sowie mit einer den Leistungstransistor in Abhängigkeit vom Laststrom ansteuerenden Steuer- oder Regeleinrichtung.

Ein derartiger elektronischer Schalter, der auch als elektronischer Schaltautomat oder elektronisches Relais bezeichnet wird, dient zum Schalten einer Last und arbeitet im Niedervoltbereich (DC 24V). Ein solcher Schalter eignet sich besonders für den Einsatz in einem Stromverteilungssystem, wie dieses beispielsweise aus der EP 1 186 086 B1 bekannt ist. Bei diesem bekannten Stromverteilungssystem sind eine Anzahl von Stromkreisen mittels eines beispielsweise auch getaktetem Netzteil von einem Gleichstrom gemeinsam gespeist, wobei die dort eingesetzten elektronischen Schalter auch die Funktionalität eines elektronischen Schutzschalters zur Beherrschung eines Überlaststroms und eines Kurzschlusses in einem einzelnen Stromkreis zu übernehmen und in einem solchen Überlast- oder Kurzschlussfall zuverlässig, gegebenenfalls im Anschluss an eine aktive Strombegrenzung, auszulösen.

In Verbindung mit einem linearen Netzteil ist ein solcher elektronischer Schalter aus der DE 20 302 275 A1 bekannt. Dieser weist in einem zwischen einem Betriebsanschluss und einem Lastanschluss verlaufenden Strompfad einen Leistungstransistor (MOSFET) und eine Regeleinrichtung auf, der zur strombegrenzenden Ansteuerung des Leistungsschalters (Halbleiterschalters) ein von einem Stromsensor im Strompfad erfasster Messwert zugeführt ist. Die Regeleinrichtung, die gemäß einer Ausführungsform einen als Komparator arbeitenden Operationsverstärker umfasst, ist zu deren Spannungsversorgung mit einer Ladungspumpe beschaltet, um die zum Betrieb des Leistungstransistors notwendige Erhöhung der Spannung an dessen Steuereingang zu erreichen, was wiederum den Einsatz einer vergleichsweise kostengünstigen N-Kanal-Variante eines Feldeffekttransistors (MOSFET) als die Last schaltendes Element ermöglicht.

Im praktischen Einsatz eines solchen elektronischen Schalters mit Ladungspumpe hat sich herausgestellt, dass nicht nur der schaltungstopologische Aufwand, sondern vielmehr auch die Leistungsverluste in Höhe von insbesondere 450mW bis 500mV bei einem Anschluss des bekannten elektronischen Schalters an ein 24V-Gleichspannungsnetz unerwünscht hoch sind.

Der Erfindung liegt die Aufgabe zugrunde, einen besonders verlustarmen, insbesondere schaltungstechnisch mit geringem Aufwand und hohem Wirkungsgrad realisierten, elektronischen Schalter (elektronisches Relais) anzugeben. Vorzugsweise soll der elektronische Schalter in einfacher Weise auch die Funktionalität eines elektronischen Schutzschalters übernehmen können.

Diese Aufgabe wird erfindungsgemäß gelöst mit den Merkmalen des Anspruchs 1. Vorteilhafte Ausgestaltungen, Varianten und Weiterbildungen sind Gegenstand der Unteransprüche.

Hierzu weist der zum Schalten einer Last nach Art eines elektronischen Relais arbeitende elektronische Schalter in einem zwischen einem Gleichspannungsanschluss und einem Lastanschluss verlaufenden Strompfad einen insbesondere als Feldeffekttransistor (MOSFET) ausgeführten Leistungstransistor, und einen den Laststrom erfassenden Stromsensor auf, dessen Messsignal an eine den Leistungstransistor steuernde Steuer- oder Regeleinrichtung geführt ist. Diese ist in den Sekundärkreis einer Wandlerschaltung mit galvanischer Trennung in Form eines Transformators geschaltet, dessen Primärkreis über eine gesteuerte, insbesondere selbstgesteuerte, Schalteranordnung an den Gleichspannungsanschluss geführt ist.

Die Erfindung geht dabei von der Überlegung aus, dass zur Realisierung eines möglichst verlustarm arbeitenden elektronischen Schalters dessen Versorgungsschaltung nicht in Form nach Art eines linearen Netzteils, sondern nach dem Prinzip eines Schaltnetzteils arbeiten sollte. Somit kann auch ein elektronischer Schalter oder ein elektronischer Schutzschalter, der nach dem einem Schaltnetzteil zugrunde liegenden Wandlerprinzips (Gleichspannungswandler) arbeitet, erkanntermaßen ebenfalls nicht nur besonders verlustarm, sondern auch mit hohem Wirkungsgrad ausgeführt werden.

Die Wandlerschaltung des elektronischen Schalters (Schutzschalters) kann mittels einer entsprechenden Elektronik gesteuert oder selbstgesteuert ausgeführt sein. Die Wandlerschaltung arbeitet daher geeigneterweise nach dem Sperr- oder Resonanzwandlerprinzip eines Gleichspannungswandlers mit galvanischer Trennung. Im Falle einer bevorzugt selbstgesteuerten Wandlerschaltung sind zweckmäßigerweise in den Primärkreis der Wandlerschaltung des elektronischen Schalters zwei auf die Primärwicklung des Transformators arbeitende Transistoren und/oder mindestens ein Bauelement zur Bildung eines Schwingkreises geschaltet.

Die Wandlerschaltung erzeugt aus der eingangsseitigen Betriebsgleichspannung des lastseitig schaltenden Leistungsschalters, z. B. einer 24V_{DC}-Eingangsspannung, eine hieraus vorzugsweise nach dem Prinzip eines Abwärtswandlers oder Tiefsetzstellers generierte Ausgangsspannung zur Versorgung der Steuer-oder Regeleinrichtung für den Leistungsschalter, z. B. eine 5v_{DC}-Versorgung- oder Betriebsspannung. Geeigneterweise weist die Steuer- oder Regeleinrichtung daher einen ausgangsseitig mit dem Steuereingang des Leistungstransistors verbundenen Operationsverstärker auf, an dessen Versorgungsanschlüsse die Ausgangsspannung der Wandlerschaltung geführt ist.

In vorteilhafter Ausgestaltung dieser Ausführung der Steuer- oder Regeleinrichtung des elektronischen Schalters steuert der Operationsverstärker den Leistungsschalter in Abhängigkeit einer Abweichung des Laststroms von einem Referenzwert an. Hierzu ist geeigneterweise einer der Komperatoreingänge des Operationsverstärkers an einen den Referenzwert bildenden Abgriff eines in den Sekundärkreis der Wandlerschaltung geschalteten Spannungsteilers geführt. Im Falle der Einbindung einer Elektronik in die Wandlerschaltung des elektronischen Schalters, der dann auch als Schutzschalter wirksam sein kann, kann der Referenzwert auch von der Elektronik vorgegeben werden.

Vorzugsweise ist eine, geeigneterweise in den Primärkreis der Wandlerschaltung geschaltete, Steuerelektronik zur Durchführung von Schutzschalterfunktionen, insbesondere zur Strombegrenzung, und/oder zur Ansteuerung der Schalteranordnung der Wandlerschaltung vorgesehen. Der elektronische Schalter ist somit über die Elektronik hinsichtlich des Nennstroms und/oder einer Strombegrenzung zur Realisierung eines Überlast- oder Kurzschlussschutzes, beispielsweise über ein Bussystem, parametrierbar.

In weiterer vorteilhafter Ausgestaltung sind an den Gleichspannungsanschluss ein Bauteil (Diode) zur Regulierung der Ausgangsspannung der Wandlerschaltung und/oder an die Primärwicklung des Transformators der Wandlerschaltung eine Diode und/oder in den Primärkreis der Wandlerschaltung mindestens ein Bauteil (Kondensator) geschaltet, das mit der Primärwicklung des Transformators einen (Resonanz-)Schwingkreis bildet.

Die mit der Erfindung erzielten Vorteile bestehen insbesondere darin, dass die Ausführung eines elektronischen Schalters oder Schutzschalters mit einer Wandlerschaltung die Spannungsversorgung für den Leistungstransistor (Halbleiterschalter) und für die Steuer- oder Regelelektronik in einer Spannungsversorgung, vorzugsweise nach Art eines Schaltnetzteils und insbesondere an einen DC 24V-Netz- oder Betriebsspannungsanschluss, zusammengeführt werden können. Zudem kann der elektronische Schutzschalter ladungspumpenfrei betrieben und schaltungstechnisch kostengünstig aufgebaut werden. Des Weiteren wird mittels des erfindungsgemäßen elektronischen Schalters oder Schutzschalters eine Reduzierung der Leistungsverluste im ca. 50%, beispielsweise von 480mW auf 240mW, erzielt.

Nachfolgend werden Ausführungsbeispiele der Erfindung anhand einer Zeichnung näher erläutert. Darin zeigen:
- Fig. 1: schematisch in einem Blockschaltbild einen nach dem Wandlerprinzip arbeitenden elektronischen Schalter (Schutzschalter) mit einer Elektronik zur Steuerung des primärseitigen Schalters einer Wandlerschaltung, und
- Fig. 2: in einer Darstellung gemäß Fig. 1 den elektronischen Schalter (Schutzschalter) mit einer selbstgesteuerten Wandlerschaltung.

Einander entsprechende Teile sind in beiden Figuren mit den gleichen Bezugszeichen versehen.

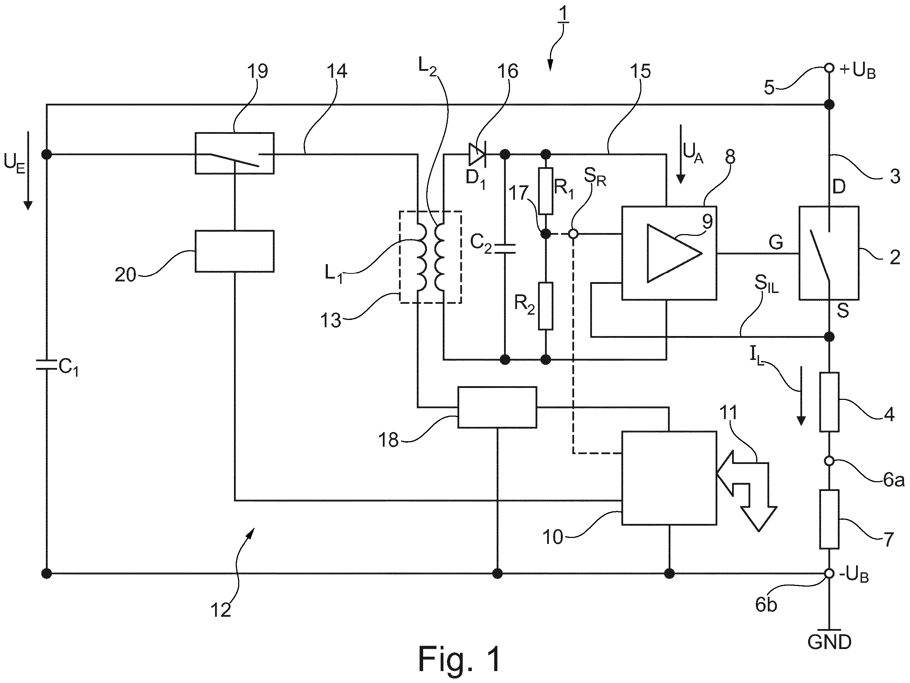

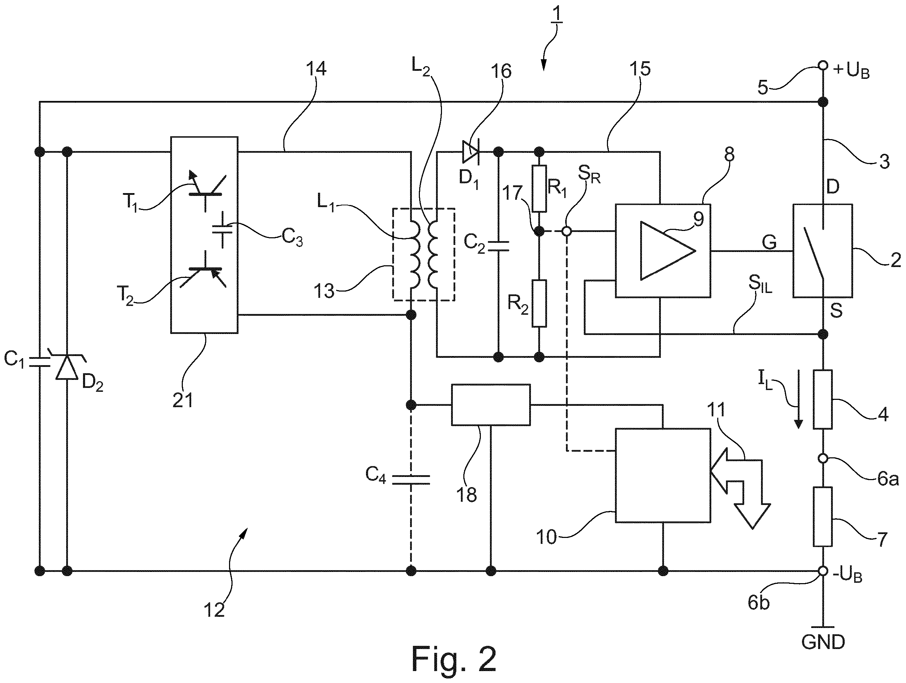

Der in den Figuren 1 und 2 schematisch dargestellte elektronische Schalter 1 umfasst einen Leistungstransistor oder Halbleiterschalter 2, insbesondere einen MOSFET, der drain-source-seitig in einen Strompfad 3 geschaltet ist. Dem Leistungstransistor 2 ist in diesem Strompfad 3 ein Stromsensor 4, beispielsweise in Form eines Shunts, nachgeschaltet. Der Strompfad 3 erstreckt sich zwischen einem Betriebsspannungsanschluss 5 und einem positiven Lastausgang 6a, an den der Pluspol einer zur schaltenden Last 7 angeschlossen wird, während deren Minuspol an einen entsprechend negativen Lastanschluss 6b des elektronischen Schalters 1 anzuschließen ist. Dieser Lastanschluss 6b ist gegen Bezugspotential (-U_{B}) bzw. Ground GND geführt. Die positive Betriebsspannung (+U_{B}) mit insbesondere U_{B} = 24 V_{DC} wird als Gleichspannung (DC) an den Betriebsspannungsanschluss 5 des Schalters 1 gelegt.

Bei angeschlossener Last 7 und geschlossenem Schalter 1, das heißt bei Ansteuerung dessen Leistungstransistor 2 in Durchlassrichtung, fließt ausgehend vom Betriebsspannungsanschluss 5 über den Strompfad 3 und die Last 7 ein Laststrom I_{L} gegen Bezugspotential oder ground GND ab. Der über den Strompfad 3 und über die Last 7 fließende Strom I_{L} wird mittels des Stromsensors 4 als Messwert beziehungsweise als entsprechendes Messsignal S_{IL} in Form des Spannungsabfalls über dem Shunt 4 an eine Steuer- oder Regeleinrichtung 8 geführt.

Die Steuer- oder Regeleinrichtung 8 umfasst im Wesentlichen einen Operationsverstärker 9, dessen einem Komperatoreingang das Messsignal S_{IL} und dessen anderem Komperatoreingang ein Referenzwert S_{R} zugeführt ist. Der Referenzwert S_{R} kann ebenso wie ein Steuersignal zum Ein- und Ausschalten des Leistungstransistors 2 von einer Steuerelektronik 10 generiert werden. Diese Steuerelektronik 10 ist beispielsweise mit Anschlüssen für ein Bussystem 11 versehen, über welches externe Signale an den elektronischen Schalter 1 gegeben und/oder Diagnose- oder Fehlersignale an eine übergeordnete Einrichtung übertragen werden können.

Der Leistungstransistor 2 ist mit dessen Drainanschluss D mit dem Betriebsspannungsanschluss 5 und mit dessen Sourceanschluss S über den Stromsensor 4 mit dem positiven Lastanschluss 6a verbunden. Das Gate G als Steuereingang des Leistungstransistors 2 ist mit dem Ausgang der Steuer- oder Regeleinrichtung 8 verbunden. Somit ist deren Operationsverstärker 9 ausgangsseitig mit dem Steuereingang G des Leistungstransistors 2 verbunden.

Die Spannungsversorgung der Steuer- oder Regeleinrichtung 8 beziehungsweise des Operationsverstärkers 9 erfolgt mittels einer Wandlerschaltung 12 mit einem Transformator 13. Die Wandlerschaltung 12 ist eingangsseitig an den Betriebsspannungsanschluss 5 und über einen Kondensator C₁ sowie gegebenenfalls weitere passive Bauelemente - beispielsweise über den Lastanschluss 6d - an Ground GND geführt. Die Eingangsspannung U_{E} der Wandlerschaltung 12 entspricht somit der Betriebsspannung U_{B}. Über den Transformator 13 erfolgt die galvanische Trennung zwischen einem Primärkreis 14 und einem Sekundärkreis 15 der Wandlerschaltung 12. In dessen Sekundärkreis 15 ist die Steuer- oder Regeleinrichtung und somit deren Operationsverstärker 9 geschaltet.

Der Sekundärkreis 15 der Wandlerschaltung 12 setzt sich ansonsten im Wesentlichen zusammen aus einem Gleichrichter 16 in Form einer Diode D₁ und einem Sieb- oder Glättungskondensator C₂. Ein ebenfalls in den Sekundärkreis 15 geschalteter Spannungsteiler R₁, R₂ ist gemäß einer Ausführungsvariante zur Bildung des Referenzwertes S_{R} vorgesehen, in dem dessen Abgriff 17 mit dem Referenzeingang der Steuer- oder Regeleinrichtung 8 beziehungsweise deren Operationsverstärker 9 verbunden ist. Durch Wahl des Widerstandsverhältnisses R₁, R₂ kann beispielsweise der Nennstrom (I_{N}) des elektronischen Schalters 1 vorgegeben oder eingestellt werden, beispielsweise indem einer der beiden Widerstände R₁, R₂ als Potentiometer ausgeführt ist.

Der Referenzwert S_{R} kann jedoch vorzugsweise auch einen Schwellwert einer aktiven Strombegrenzung des Schalters 1 festlegen, wobei dieser Schwellwert beispielsweise das 1,5-fache bis 2-fach des jeweiligen Nennstroms I_{N} betragen kann. Im Überlast- oder Kurzschlussfall kann somit der über den Strompfad 3 fließende Laststrom I_{L} mittels des Leistungstransistors 2 aktiv begrenzt werden, in dem dieser mittels der Steuer- oder Regeleinrichtung 8 vom beispielsweise zuvor vollständig leitenden Zustand entsprechend zugesteuert wird. Die Strombegrenzung erfolgt dann auf den eingestellten oder vorgegebenen Referenzwert S_{R}, wobei nach Ablauf einer eingestellten Auslösezeit eine vollständige Sperrung des Leistungstransistors 2 erfolgt und somit die Last 7 abgeschaltet wird (Auslösefall).

Die Wandlerschaltung 12 arbeitet geeigneterweise nach Art eines Schaltnetzteils mit Abwärtsregelung, sodass die der Betriebsspannung U_{B} entsprechende Eingangsspannung U_{E} der Wandlerschaltung 12 sekundärseitig in eine vergleichsweise niedrige Ausgangsspannung U_{A} transformiert wird. Mittels dieser wird die Steuer- oder Regeleinrichtung 8 energetisch versorgt. Die Ausgangsspannung U_{A} der Wandlerschaltung 12 kann beispielsweise 5V betragen. Die Wandlerschaltung 12 kann jedoch auch als Aufwärtsregler arbeiten, beispielsweise um je nach verwendetem Transistortyp an dessen Gate G eine höhere Spannung als an dessen Drain D zu erzielen.

Während die Sekundärwicklung L₂ des Transformators 13 in den Sekundärkreis 15 geschaltet ist, ist die Primärwicklung L₁ des Transformators 3 in den Primärkreis 14 geschaltet. Im Primärkreis 14 der Wandlerschaltung 12 ist eine Glättungs- und/oder Gleichrichterschaltung 17 vorgesehen, die beispielsweise aus Widerständen und Kondensatoren sowie Dioden (Zehnerdioden) aufgebaut sein kann und zur Spannungsversorgung der Elektronik 10 dient. Im Primärkreis 14 der Wandlerschaltung 12 liegt zudem eine Diode D₂ zur Regulierung der Ausgangsspannung U_{A}.

Während gemäß der Ausführungsform nach Figur 1 die Wandlerschaltung 12 nach dem Sperrwandlerprinzip mit einem in den Primärkreis 14 geschaltet Transistor oder Leistungstransistor 19 ausgeführt ist, arbeitet die Wandlerschaltung 12 gemäß der Ausführungsform nach Figur 2 nach dem Resonanz- oder Flusswandlerprinzip. Bei dieser Ausführungsform wir der Transistor 19 mit Rechteckimpulsen angesteuert, deren Pulsfrequenz insbesondere größer oder gleich 16kHz beträgt. Eine demzufolge entsprechend primärseitig erzeugte Wechselspannung wird auf die Sekundärseite des Transistors 13 transformiert und dort gleichgerichtet, um als Ausgangsspannung U_{A} (Gleichspannung, DC) zur Verfügung zu stehen.

Bei der Ausführungsform gemäß Figur 1 ist der in den Primärkreis 14 geschaltete Transistor (Leistungstransistor) 19 der Wandlerschaltung 12 ansteuerseitig mit einem Treiber in Form beispielsweise eines pulsweiten Modulators (PWM) 20 verbunden, der seinerseits mit der Elektronik 10 verbunden und von dieser angesteuert ist.

Bei der Ausführungsform gemäß Figur 2 bildet ein Kondensator C₃ und/oder C₄ zusammen mit der Induktivität des Transformators 13, insbesondere dessen Primärwicklung L₁ einen Schwingkreis. Die Induktivität kann auch durch eine zusätzliche Spule gebildet sein. Bei dieser Ausführungsform arbeiten geeigneter Weise zwei Transistoren T₁, T₂, beispielsweise im Gegentakt zur Erzeugung einer primärseitigen Wechselspannung, auf die Primärwicklung L₁ des Transformators 13. Die auf die Sekundärseite des Transistors 13 transformierte Wechselspannung wird wiederum gleichgerichtet und steht als Ausgangsspannung U_{A} (Gleichspannung, DC) zur Verfügung. Hierzu sind die Transistoren T₁ und T₂ in nicht näher dargestellter Art und Weise innerhalb einer Transistorschaltung 20 mit weiteren Bauteilen (Widerständen, Kondensatoren) derart beschaltet, dass beispielsweise stets einer der beiden Transistoren durchgeschaltet ist, während dann der andere Transistor sperrt und umgekehrt.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit den Ausführungsbeispielen beschriebenen Einzelmerkmale auch auf andere Weise miteinander kombinierbar, ohne den Gegenstand der Erfindung zu verlassen.

### Bezugszeichenliste

- 1: Elektronischer Schutz-/Schalter
- 2: Leistungstransistor/MOSFET
- 3: Strompfad
- 4: Stromsensor/Shunt
- 5: Betriebsspannungsanschluss
- 6a: (positiver) Lastanschluss
- 6b: (negativer) Lastanschluss
- 7: Last
- 8: Steuer-/Regeleinrichtung
- 9: Operationsverstärker
- 10: Elektronik
- 11: Bussystem
- 12: Wandlerschaltung
- 13: Transformator
- 14: Primärkreis
- 15: Sekundärkreis
- 16: Gleichrichter / Diode
- 17: Abgriff
- 18: Gleichrichter- / Glättungsschaltung
- 19: Leistungs- / Transistor
- 20: Treiber/PWM
- 21: Transistorschaltung

- Cₙ: Kondensator (n = 1, 2, 3, 4)
- D: Drain
- G: Gate
- GND: Ground
- I_{L}: Laststrom
- L₁: Primärwicklung
- L₂: Sekundärwicklung
- R_{1,2}: Ohmscher Widerstand
- S: Source
- S_{IL}: Messwert/-signal
- S_{R}: Referenzwert
- U_{E}: Eingangsspannung
- U_{A}: Ausgangsspannung
- U_{B}: Betriebsspannung

## Patentansprüche

1. Elektronischer Schalter (1) zum Schalten einer Last (7), mit einem zwischen einem Betriebsspannungsanschluss (5) und einem Lastanschluss (6a) verlaufenden Strompfad (3), in den ein Leistungstransistor (2) und ein den Laststrom (I_{L}) erfassender Stromsensor (4) geschaltet sind, sowie mit einer den Leistungstransistor (2) in Abhängigkeit vom Laststrom (lL) ansteuerenden Steuer- oder Regeleinrichtung (8, 9),
**dadurch gekennzeichnet,**
**dass** die Steuer- oder Regeleinrichtung (8, 9) in den Sekundärkreis (15) einer Wandlerschaltung (12) mit einem Transformator (13) geschaltet ist, dessen Primärkreis (14) über eine gesteuerte Schalteranordnung (19, 20) an den Betriebsspannungsanschluss (5) geführt ist.

2. Elektronischer Schalter (1) nach Anspruch 1,
**dadurch gekennzeichnet,**
**dass** die Steuer- oder Regeleinrichtung (8) einen ausgangsseitig mit dem Steuereingang (G) des Leistungstransistors (2) verbundenen Operationsverstärker (9) umfasst, an den zu dessen Versorgung die Ausgangsspannung (U_{A}) der Wandlerschaltung (12) geführt ist.

3. Elektronischer Schalter (1) nach Anspruch 2,
**dadurch gekennzeichnet,**
**dass** der Operationsverstärker (9) den Leistungsschalter (2) in Abhängigkeit einer Abweichung des Laststroms (I_{L}) von einem Referenzwert (S_{R}) ansteuert.

4. Elektronischer Schalter (1) nach Anspruch 3,
**dadurch gekennzeichnet,**
**dass** einer der Komperatoreingänge des Operationsverstärkers (9) an einen den Referenzwert (S_{R}) bildenden Abgriff (17) eines in den Sekundärkreis (15) der Wandlerschaltung (12) geschalteten Spannungsteilers (R₁, R₂) geführt ist.

5. Elektronischer Schalter (1) nach einem der Ansprüche 1 bis 4,
**dadurch gekennzeichnet,**
**dass** eine in den Primärkreis (14) der Wandlerschaltung (12) geschaltete Steuerelektronik (10) zur Durchführung von Schutzschalterfunktionen, insbesondere zur Strombegrenzung, und/oder zur Ansteuerung der Schalteranordnung (19, 21) der Wandlerschaltung (12) vorgesehen ist.

6. Elektronischer Schalter (1) nach einem der Ansprüche 1 bis 5,
**dadurch gekennzeichnet,**
**dass** in den Primärkreis (14) der Wandlerschaltung (12) zur Regulierung dessen Ausgangsspannung (U_{A}) und/oder an die Primärwicklung (14) des Transformators (13) der Wandlerschaltung (12) eine Diode (D) geschaltet ist.

7. Elektronischer Schalter (1) nach einem der Ansprüche 1 bis 6,
**dadurch gekennzeichnet,**
**dass** im Primärkreis (14) der Wandlerschaltung (12) zwei auf die Primärwicklung (L₁) des Transformators (13) arbeitende Transistoren (T₁, T₂) verschaltet sind.

8. Elektronischer Schalter (1) nach einem der Ansprüche 1 bis 7,
**dadurch gekennzeichnet,**
**dass** die Wandlerschaltung (12) nach dem Sperr-, Resonanz- oder Flusswandlerprinzip arbeitet.

9. Elektronischer Schalter (1) nach einem der Ansprüche 1 bis 8,
**dadurch gekennzeichnet,**
**dass** die Wandlerschaltung (12) selbststeuernd ausgeführt ist.

10. Elektronischer Schalter (1) nach einem der Ansprüche 1 bis 9,
**dadurch gekennzeichnet,**
**dass** in den Primärkreis (14) der Wandlerschaltung (12) ein Kondensator (C₄) zur Bildung eines Schwingkreises, insbesondere zusammen mit einer (primärseitigen) Transformatorinduktivität, geschaltet ist.

## Claims

1. Electronic switch (1) for switching a load (7), having a current path (3) that runs between an operating voltage connection (5) and a load connection (6a) and in which a power transistor (2) and a current sensor (4) sensing the load current (I_{L}) are connected, and also having an open-loop or closed-loop control device (8, 9) actuating the power transistor (2) on the basis of the load current (I_{L}),
**characterized**
**in that** the open-loop or closed-loop control device (8, 9) is connected in the secondary loop (15) of a converter circuit (12) having a transformer (13), the primary loop (14) of which is routed to the operating voltage connection (5) via a controlled switch arrangement (19, 20).

2. Electronic switch (1) according to Claim 1,
**characterized**
**in that** the open-loop or closed-loop control device (8) comprises an operational amplifier (9) whose output side is connected to the control input (G) of the power transistor (2) and to which the output voltage (U_{A}) of the converter circuit (12) is routed to supply power to said operational amplifier.

3. Electronic switch (1) according to Claim 2,
**characterized**
**in that** the operational amplifier (9) actuates the power switch (2) on the basis of a deviation in the load current (I_{L}) from a reference value (S_{R}).

4. Electronic switch (1) according to Claim 3,
**characterized**
**in that** one of the comparator inputs of the operational amplifier (9) is routed to a tap (17), forming the reference value (S_{R}), of a voltage divider (R₁, R₂) connected in the secondary loop (15) of the converter circuit (12).

5. Electronic switch (1) according to one of Claims 1 to 4,
**characterized**
**in that** control electronics (10) connected in the primary loop (14) of the converter circuit (12) are provided for performing protective switch functions, in particular for current limiting, and/or for actuating the switch arrangement (19, 21) of the converter circuit (12).

6. Electronic switch (1) according to one of Claims 1 to 5,
**characterized**
**in that** a diode (D) is connected in the primary loop (14) of the converter circuit (12) for the purpose of regulating the output voltage (U_{A}) of said primary loop and/or to the primary winding (14) of the transformer (13) of the converter circuit (12).

7. Electronic switch (1) according to one of Claims 1 to 6,
**characterized**
**in that** two transistors (T₁, T₂) operating on the primary winding (L₁) of the transformer (13) are interconnected in the primary loop (14) of the converter circuit (12).

8. Electronic switch (1) according to one of Claims 1 to 7,
**characterized**
**in that** the converter circuit (12) operates on the basis of the flyback, resonant or flux converter principle.

9. Electronic switch (1) according to one of Claims 1 to 8,
**characterized**
**in that** the converter circuit (12) is configured to be self-controlling.

10. Electronic switch (1) according to one of Claims 1 to 9,
**characterized**
**in that** a capacitor (C₄) for forming a resonant circuit, in particular together with a (primary-side) transformer inductance, is connected in the primary loop (14) of the converter circuit (12).

## Revendications

1. Commutateur électronique (1) pour le branchement d'une charge (7), présentant
un parcours de courant (3) qui s'étend entre une borne (5) de raccordement à la tension de service et une borne (6a) de raccordement de la charge et dans lequel sont prévus un transistor de puissance (2) et un capteur de courant (4) qui saisit le courant de charge (I_{L}), ainsi que
un dispositif de commande ou de régulation (8, 9) qui commande le transistor de puissance (2) en fonction du courant de charge (I_{L}),
**caractérisé en ce que**
le dispositif de commande ou de régulation (8, 9) est prévu dans la boucle secondaire (15) d'un circuit de conversion (12) dont la boucle primaire (14) est raccordée à la borne (5) de raccordement à la tension de service par l'intermédiaire d'un ensemble (19, 20) de commutateur asservi.

2. Commutateur électronique (1) selon la revendication 1, **caractérisé en ce que** le dispositif de commande ou de régulation (8) comporte à sa sortie un amplificateur opérationnel (9) raccordé à l'entrée de commande (G) du transistor de puissance (2) et sur lequel la tension de sortie (U_{A}) du circuit de conversion (12) est appliquée pour assurer son alimentation.

3. Commutateur électronique (1) selon la revendication 2, **caractérisé en ce que** l'amplificateur opérationnel (9) commande le commutateur de puissance (2) en fonction d'un écart entre le courant de charge (I_{L}) et une valeur de référence (S_{R}).

4. Commutateur électronique (1) selon la revendication 3, **caractérisé en ce que** l'une des entrées de comparaison de l'amplificateur opérationnel (9) est raccordée à une borne de prélèvement (17), formant la valeur de référence (S_{R}), d'un diviseur de tension (R₁, R₂) prévu dans la boucle secondaire (15) du circuit de conversion (12).

5. Commutateur électronique (1) selon l'une des revendications 1 à 4, **caractérisé en ce qu'**une électronique de commande (10) est prévue dans la boucle primaire (14) du circuit de conversion (12) pour exécuter des fonctions de commutateur de protection, en particulier de limitation du courant, et/ou pour commander l'ensemble (19, 21) de commutateur du circuit de conversion (12).

6. Commutateur électronique (1) selon l'une des revendications 1 à 5, **caractérisé en ce qu'**une diode (2) est prévue dans la boucle primaire (14) du circuit de conversion (12) pour réguler sa tension de sortie (U_{A}) et/ou dans l'enroulement primaire (14) du transformateur (13) du circuit de conversion (12).

7. Commutateur électronique (1) selon l'une des revendications 1 à 6, **caractérisé en ce que** deux transistors (T₁, T₂) qui travaillent sur l'enroulement primaire (L₁) du transformateur (3) sont prévus dans la boucle primaire (14) du circuit de conversion (12).

8. Commutateur électronique (1) selon l'une des revendications 1 à 7, **caractérisé en ce que** le circuit de conversion (12) fonctionne selon le principe de blocage, le principe de résonance ou le principe de conversion de flux.

9. Commutateur électronique (1) selon l'une des revendications 1 à 8, **caractérisé en ce que** le circuit de conversion (12) est auto-asservi.

10. Commutateur électronique (1) selon l'une des revendications 1 à 9, **caractérisé en ce qu'**un condensateur (C₄) est prévu dans la boucle primaire (14) du circuit de conversion (12) pour former un circuit oscillant, en particulier avec une inductance (du côté primaire) du transformateur.
